# EUROPEAN PATENT APPLICATION

(11) **EP 0 845 808 A2**
(43) Date of publication of application: **03.06.1998**
(21) Application number: 97120013.4
(22) Date of filing: 14.11.1997
(51) Int. Cl.: H01L 23/522, H01L 21/768, H01L 23/528

(54) **Multilayer wiring structure including via holes**

(30) Priority: 28.11.1996 JP 317600/96
(71) Applicant: NEC CORPORATION, Tokyo (JP)
(72) Inventor: Kinoshita, Masaaki, Minato-ku, Tokyo (JP)
(74) Representative: Betten & Resch

(57) **Abstract**

The semiconductor device according to the present invention includes a first wiring formed on a first insulating film, a second insulating film provided on the first wiring, a second wiring provided on the second insulating film, and a plurality of via holes for electrically connecting the first wiring and the second wiring where the first wiring and the second wiring intersect, provided in a via hole formation region, wherein the first wiring is divided in the via hole formation region into a first branch wiring and a second branch wiring, and the widths of the first branch wiring and the second branch wiring are respectively 7 µm or less.

## Description

### BACKGROUND OF THE INVENTION

### Field of the Invention

The present invention relates to a wiring structure, and more particularly to a structure of wirings in a via hole region which connects multilayered wirings.

### Description of the Related Art

In a semiconductor device having multilayered wirings, when forming an insulating film between first wirings on a lower layer and second wirings on an upper layer, a silica film (spin-on-glass film) is provided on the insulating film for the purpose of reducing the step height of, and flattening, the first wirings. This will be described in the following by making reference to the drawings.

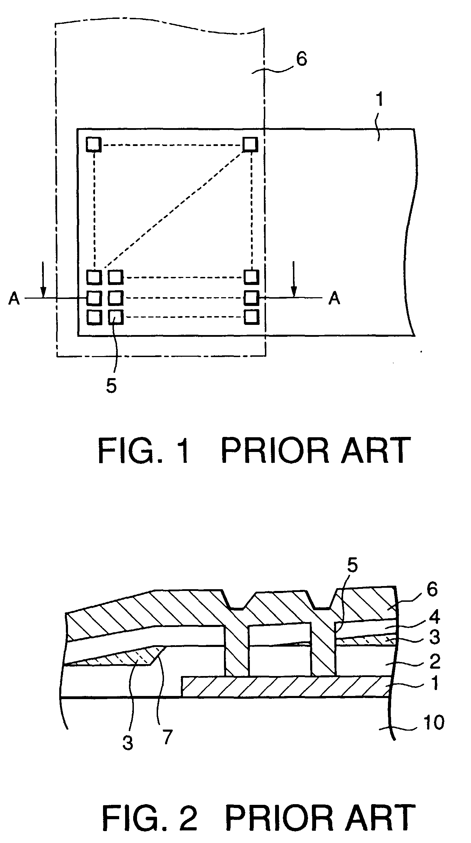

As shown in Fig. 1, when a first wiring 1 formed on an insulating film of, for example, an oxide film is to be connected to a second wiring 6 by means of via holes 5 formed on a layer insulating film (not shown), a large number of via holes 5 are arranged in the intersecting region of the first wiring 1 and the second wiring 6 for the purpose of reducing the electrical resistance of the through holes. Next, referring to Fig. 2, the method of manufacturing the wiring structure will be described. First, a first wiring 1 made of aluminum tungsten, silicide, polycrystalline silicon or the like formed on an insulating film 10 above a semiconductor substrate is patterned by photolithography. Then, a plasma oxide film 2 is grown on the surface at a low temperature by taking the melting point of the first wiring 1 into consideration. Next, after coating the entire surface with silica solution, a silica film 3 is formed by heating, and unwanted silica film 3 is removed by etch-back. Next, a plasma oxide film 4 is grown again at a low temperature, and via holes 5 are opened by photolithography technique. Next, a second wiring 6 is grown and the second wiring 6 is patterned using a photoresist.

In the etch-back process of the silica film 3 mentioned above, the silica film 3 tends to be left unetched on the oxide film 2 above the first wiring 1 even in the flat sections because of the large width of the first wiring 1. When the silica film 3 remains on the oxide film 2 after the etch-back of the silica film 3 as shown in Fig. 2, the silica film 3 will be exposed on the side walls of the via holes 5 after the formation of the through holes. In such a case, the silica film 3 will absorbs the moisture and initiate, after the formation of the second wiring 6, the corrosion of the second wiring 6 on the side-walls of the via holes 5, causing an increase in the resistance and disconnection.

A first technique of preventing the exposure of the silica film 3 on the side-walls of the through holes 5 is to completely remove the silica film 3 on the oxide film 2 above the first wiring 1 through overetching in the etch-back process of the silica film 3.

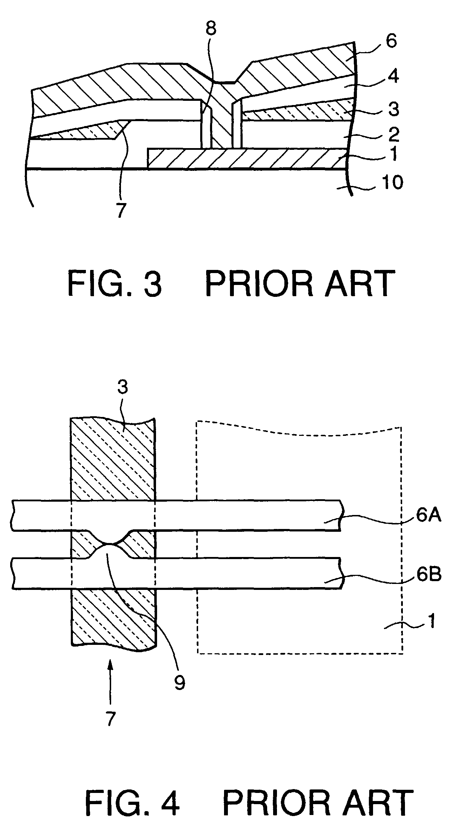

A second technique is a method of forming a sidewall. As shown in Fig. 3, according to this method, an insulating film such as a nitride film or an oxide film is grown on the entire surface after opening the via holes 5, then the insulating film is subjected to an etch-back, and the exposure of the silica film 3 on the sidewalls of the via holes 5 is prevented by leaving the nitride film or the oxide film only on the sidewalls of the via holes 5 as sidewalls 8.

In the first technique for handling the problem, the remaining amount of the silica film 3 in the end section of the first wiring 1 where an appropriate amount of the silica film 3 is desired to be left becomes insufficient because of the overetching of the silica film 3. As a result, the level difference 7 at the end section of the first wiring 1 becomes large, and it leads to a difficulty in that the very object of realizing flatness through the formation of the silica film 3 is self-defeated. When the flatness is poor, short-circuiting occurs between second metallic wirings 6A and 6B caused by etching residues as a result of insufficient etching of the second wiring 6, on the level difference 7 in the end section of the first wiring 1, as shown in Fig. 4.

In the second technique, additional processes have to be introduced and the production time has to be prolonged due to growing of the nitride or oxide film and the subsequent etch-back of the film, and it results in the problem that the price of the semiconductor device has to be raised.

### BRIEF SUMMARY OF THE INVENTION

### Object of the Invention

It is therefore the object of the present invention to provide a wiring structure which makes it possible to prevent the increase in the electrical resistance and the disconnection in the via hole formation region without increasing the manhours.

### Summary of the Invention

The semiconductor device according to this invention includes a first wiring formed on a first insulating film, a second insulating film provided on the first wiring, a second wiring provided on the second insulating film, and a plurality of via holes for electrically connecting the first wiring and the second wiring provided in the via hole formation region where the first wiring and the second wiring intersect. The first wiring is divided into a first branch wiring and a second branch wiring in the via hole formation region, and the width of the first branch wiring and the second branch wiring are respectively 7 µm or less.

### BRIEF DESCRIPTION OF THE DRAWINGS

The above-mentioned and other objects, features and advantages of this invention will become more apparent by reference to the following detailed description of the invention taken in conjunction with the accompanying draings, wherein:
Fig. 1 is a plane view showing a conventional through hole section connecting the first wiring and the second wiring;
Fig. 2 is a sectional view along the line A-A in Fig. 1;
Fig. 3 is a sectional view showing another example of the conventional via hole section;
Fig. 4 is a plan view showing the intersection part of the wirings for describing the problems in the conventional device;
Fig. 5 is a plan view for describing a first embodiment of this invention;
Fig. 6 is a plan view for describing a second embodiment of this invention;
Fig. 7 is a plan view for describing a third embodiment of this invention; and
Fig. 8 is a sectional view for describing this invention.

### DETAILED DESCRIPTION OF THE INVENTION

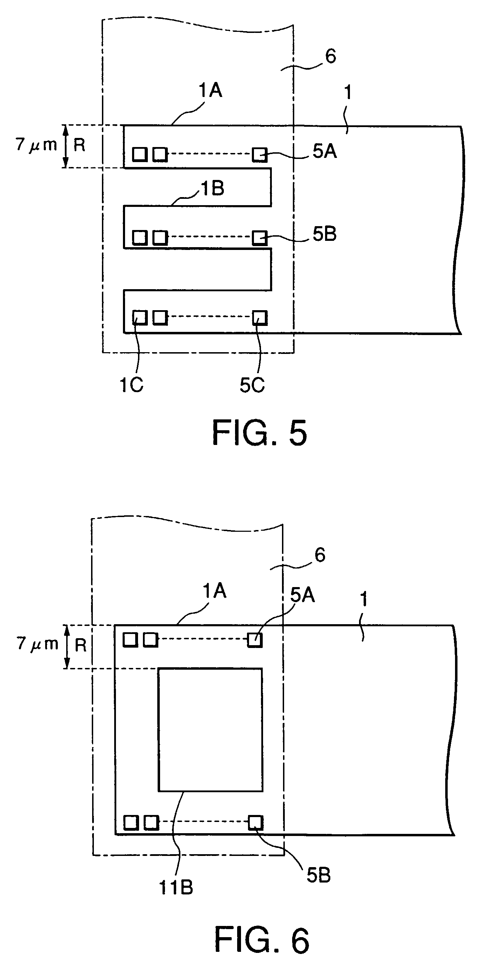

Referring to Fig. 5, a first embodiment of this invention will be described. The feature of this invention resides in the wiring shape of the portion being the region where a first wiring 1 and a second wiring 6 intersect and where a plurality of via holes for electrically connecting the first wiring 1 and the second wiring 6 are connected. As shown in Fig. 5, a plurality of via hole trains 5A, 5B, and 5C are formed. The shape of the end section of the first wiring 1 is that of a comb which is formed by connecting all of a first branch wiring 1A, a second branch wiring 1B, and a third branch wiring 1C having their respective through hole trains in the region outside a via hole formation region. With such a shape, the distance from the respective via hole trains to either edge of the first wiring 1 can be represented by multiples of the width R of the branch wiring.

The following test was carried out for respective cases of 5, 7, and 10 µm for the branch wiring width R of the first wiring 1.

When an oxide film (with a thickness of about 600 nm) is formed on the patterned first wiring 1, a ruggedness corresponding to the patterning of the first wiring 1 was formed on the surface of the oxide film. When the oxide film was coated with silica solution subsequently, it was confirmed that the silica solution did not stay on the protruded parts because of the surface tension of the silica solution.

When the width of the branch wiring was chosen to be 10 µm, considerable amount of the silica solution stayed on the protruded parts formed by the oxide film deposited on the wiring. Since the complete removal by etch-back of that amount of silica would lead to a problem on the flatness of the surface, it was not practical to remove all of silica from the surface.

When the width of the branch wiring was chosen to be 7 µm, a small amount of silica solution stayed on the protruded parts formed by the oxide film deposited on the wiring. It was found that flatness of the surface was not much affected even if that amount of silica was removed by etch-back.

When the width of the branch wiring was selected to be 3 µm, little silica solution stayed on the protruded parts formed on the oxide film deposited on the wiring. Accordingly, flatness of the surface was not at all affected even if the surface was subjected to etch-back.

As is clear from the above results, it was found that even if the surface is coated with silica solution, not much silica solution remains on the protruded parts owing to the surface tension of the silica solution provided that the width of the branch wiring R is restricted to 7 µm or less.

In the first embodiment shown in Fig. 5, only a small amount of silica that can be etched back will remain on the branch wiring regions that are connected to the via holes provided that the width R of the plurality of branch wirings is chosen to be 7 µm or less. Accordingly, the effect of the silica film in the opening of the via holes can be eliminated. It should be noted that the width of the branch wiring depends on the width of the via hole, and it is necessary to have the width of the branch wiring which is at least twice the width of the through hole. For example, when the width of the via hole is 0.5 µm, the width of the branch wiring of 1 µm or more is necessary.

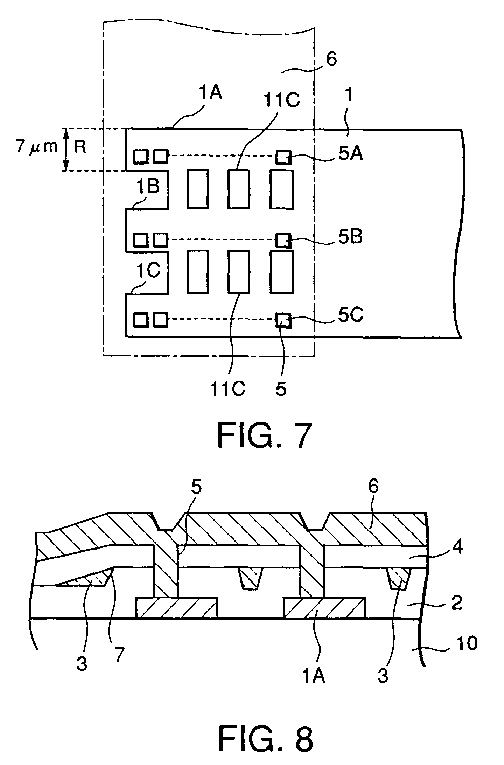

Next, referring to Fig. 5 and Fig. 8, the production of the device will be described. First, after the formation of a conductive film, consisting of aluminum, tungsten, polycrystalline silicon or a silicide, to a thickness of 300 - 500 nm on an insulating film 10, consisting of an oxide film or the like formed on a semiconductor substrate, the first wiring 1 having a shape as shown in Fig. 5 is formed by patterning. Next, a plasma oxide film 2 is formed to a thickness of about 600 nm at a low temperature (about 400°C), considering the melting point of the first wiring, as an insulating film to avoid the contact between the silica film and the first wiring 1. Next, the entire surface coated with silica solution is heated to 300 - 400°C to form a silica film 3 in order to relax the level difference 7 created as a result of the formation of the first wiring 1. At this time, the unwanted silica film 3 remaining on the plasma oxide film 2 above the wiring 1 is thinned out or removed by etch-back. The coating silica solution on the comb teeth 1A, 1B, and 1C at the end section of the first wiring 1 flows into the spaces (lower portions) between the patterns, so that little silica film 3 is formed on the comb teeth. Even if the silica film is formed to a small extent, it will be removed completely by the etch-back.

Next, a plasma oxide film 4 is formed again at a low temperature to a thickness of about 400 nm in order to avoid the contact between the silica film 3 and the second wiring 6. Then, the via holes 5 are formed in the comb-tooth shaped patterns st the end section of the first wiring 1 by patterning the plasma oxide film 4. Next, after forming by sputtering a film of a metal such as aluminum to a thickness of about 600 - 900 nm and patterning the metallic film, the second wiring 6 which is connected to the first wiring 1 is formed.

According to the first embodiment, since the portion of the first wiring where the via holes 5 are formed is shaped in the form of a comb, the silica film can be removed completely by the etch-back and the level difference can also be relaxed. Accordingly, the silica film 3 will not be exposed to the interior of the via holes 5, which improves the reliability of the semiconductor device without giving rise to the corrosion of the second wiring 6, increase in the resistance, disconnection or the like.

Referring to Fig. 6, a second embodiment of this invention will be described. In this embodiment, the first wiring 1 is formed in a ring shape. Namely, a punched portion 11B is formed between a first via hole train 5A and a second via hole train 5B, and the shape of the first wiring 1 in the through hole formation region is made ringlike. In other words, in this embodiment, both ends of a first branch wiring 1A and a second branch wiring 1B are connected to form a ring. In this embodiment, an effect similar to that of the first embodiment can be realized by setting the wiring width R of the ringlike portion of the first wiring 1 to be 7 µm or less. The method of production of the structure is similar to that of the first embodiment.

Next, referring to Fig. 7, a third embodiment of this invention will be described. In this embodiment, the punched section 11B of the second embodiment is divided into a plurality of punched sections 11C. With this shape, the are of the first wiring 1 becomes larger than that of the second embodiment, and a reduction in the resistance is made possible. In this embodiment, an effect similar to that of the first embodiment can also be realized by setting the wiring width R of the first wiring 1 in the through hole formation region to be 7 µm or less. The method of production of the structure is similar to that of the first embodiment.

Although the invention has been described with reference to specific embodiments, this description is not meant to be construed in a limiting sense. Various modifications of the disclosed embodiments will become apparent to persons in the art upon reference to the description of the invention. It is therefore contemplated that the appended claims will cover any modifications or embodiments as fall within the true scope of the invention.

## Claims

1. In a semiconductor device including a first wiring and a second wiring connected electrically via an insulating film to said first wiring by means of a plurality of via holes, the semiconductor device characterized in that said plurality of via holes include a first via hole train and a second via hole train, and said first wiring includes a first branch wiring and a second branch wiring connected to said first via hole train and said second via hole train, respectively, wherein the edge part of said first branch wiring and the edge part of said second branch wiring are separated by a specified distance at least at one location.

2. The semiconductor device as claimed in claim 1, wherein one end of said first branch wiring and one end of said second branch wiring are connected and the other end of said first branch wiring and the other end of said second branch wiring are separated by a specified distance, thereby said first wiring forming the shape of a comb.

3. The semiconductor device as claimed in claim 1, wherein one end of said first branch wiring and one end of said second branch wiring are connected and the other end of said first branch wiring and the other end of said second branch wiring are connected, thereby said first wiring forming the shape of a ring.

4. The semiconductor device as claimed in claim 1, wherein the width of said first branch wiring and said second branch wiring is 7 µm or less.

5. The semiconductor device as claimed in claim 4, wherein the width of said first branch wiring and said second branch wiring is greater than about twice the width of said via hole.

6. The semiconductor device as claimed in claim 1, wherein said first branch wiring and said second branch wiring are connected at a plurality of parts.

7. A semiconductor device comprising: a first wiring formed on a first insulating film, a second insulating film provided on said first wiring, a second wiring provided on said second insulating film, and a plurality of via holes, provided in a via hole formation region where said first wiring and said second wiring intersect, for electrically connecting said first wiring and said second wiring, wherein said first wiring is divided in said via hole formation region into a first branch wiring and a second branch wiring and the widths of said first branch wiring and said second branch wiring are respectively 7 µm or less.

8. The semiconductor device as claimed in claim 7, wherein the width of said first branch wiring and said second branch wiring is larger than about twice the width of said via hole.

9. In a semiconductor device including a first wiring and a second wiring electrically connected via an insulating film to said first wiring by means of a plurality of via holes, the semiconductor device characterized in that said plurality of via holes include a first through hole train and a second through hole train, said first wiring is connected to said first via hole train and said second via hole train respectively, and said first wiring has at least one punched part in the region between said first via hole train and said second via hole train.

10. The semiconductor device as claimed in claim 9, wherein said punched part exists in a plural number.

11. The semiconductor device as claimed in claim 9, wherein the width of said first branch wiring and said second branch wiring is 7 µm or less.

12. The semiconductor device as claimed in claim 11, wherein the width of said first branch wiring and said second branch wiring is greater than about twice the width of said via hole.
